(19) **Europäisches Patentamt**

**European Patent Office**

**Office européen des brevets**

(11) **EP 0 592 797 B1**

(12) **EUROPÄISCHE PATENTSCHRIFT**

(45) Veröffentlichungstag und Bekanntmachung des Hinweises auf die Patenterteilung:
**30.10.1996 Patentblatt 1996/44**

(51) Int. Cl.[6]: **C04B 35/50**, C04B 35/65, H01L 39/24, C04B 35/00

(21) Anmeldenummer: **93113778.0**

(22) Anmeldetag: **28.08.1993**

(54) **Verfahren zur Herstellung eines rotationssymmetrischen Formteiles eines Hochtemperatursupraleiters**

Method for manufacturing rotation symetrical high temperature superconductor workpieces

Procédé pour la fabrication de pièces de forme à symétrie rotative en matériaux supraconducteur à haute température

(84) Benannte Vertragsstaaten:
**CH DE FR GB IT LI**

(30) Priorität: **12.10.1992 DE 4234310**

(43) Veröffentlichungstag der Anmeldung:
**20.04.1994 Patentblatt 1994/16**

(73) Patentinhaber: **ABB RESEARCH LTD.**
**CH-8050 Zürich 11 (CH)**

(72) Erfinder:
• **Baumann, Thomas, Dr.**
**CH-5430 Wettingen (CH)**
• **Unternährer, Peter**
**CH-8116 Würenlos (CH)**

(74) Vertreter: **Rzehak, Herbert**
**c/o ABB Management AG,**
**Abt. TEI-Immaterialgüterrecht**
**5401 Baden (CH)**

(56) Entgegenhaltungen:
**EP-A- 0 482 221      DE-A- 4 019 368**

• **PATENT ABSTRACTS OF JAPAN vol. 14, no. 523 (M-1049) 16. November 1990 & JP-A-02 220 810 (SUMITOMO HEAVY IND., LTD.) 4. September 1990**
• **PATENT ABSTRACTS OF JAPAN vol. 10, no. 98 (C-339) 15. April 1986 & JP-A-60 228 679 (KOGYO GIJUTSUIN) 13. November 1985**

# Beschreibung

## TECHNISCHES GEBIET

Bei der Erfindung wird ausgegangen von einem Verfahren zur Herstellung eines rotationssymmetrischen Formteiles eines Hochtemperatursupraleiters nach dem Oberbegriff des Patentanspruchs 1.

## STAND DER TECHNIK

Mit dem Oberbegriff des Patentanspruchs 1 nimmt die Erfindung auf einen Stand der Technik Bezug, wie er aus der DE-A1-4 019 368 bekannt ist. Dort wird ein Verfahren zur Herstellung von Zylindern bzw. Ringen auf der Basis eines Wismut-2Schichtkuprates beschrieben. Hierbei wird die homogene Schmelze in eine rotierende, kalte Schmelzform eingeschleudert. Durch sehr unterschiedliche Erstarrungsgeschwindigkeiten am Rand und im Probeninneren entsteht ein Gefüge mit recht unterschiedlicher Dichte und voller innerer Spannungen. Über Werte der kritischen Stromdichte wird nichts berichtet.

Aus der EP-A1-0 482 221 ist ein Verfahren zum Herstellen eines keramischen Hochtemperatursupraleiters vom Typ Bi-Sr-Ca-Cu-O bekannt, bei dem das Verhältnis von Bi : Sr : Ca : Cu bei (2-x) : 2 : (1+v) : (2+w) liegt, $0,05 \leq x \leq 0,6$; $0 < v \leq 0,5$ und $0 < w \leq 0,5$. Oxide von Bi und Cu sowie Karbonate von Ca und Sr werden unterhalb der Schmelztemperatur, vorzugsweise bei 800 °C, in eine Bi-2Schichtverbindung umgewandelt. Dann wird die Pulvermischung in eine gewünschte Form gepresst und wenige Grad oberhalb der Schmelztemperatur 1 h unter 1 bar $O_2$ erschmolzen. In einem 2Stufenprozess (13 h bei 860 °C unter 1 bar $O_2$ und 60 h bei 800 °C in Luft) wird das Material nachbehandelt und in die Bi-2Schichtverbindung umgewandelt. Das anschliessende Abkühlen erfolgte unterhalb 700 °C in einer $N_2$-Atmosphäre. Ohne Magnetfeld lag die kritische Stromdichte $j_c$ bei 1,6 kA/cm$^2$. Mit x = 0,05 und einer Nachbehandlung von 18 h bei 800 °C wurde $j_c(B=0)$ = 2,12 kA/cm$^2$ gemessen.

Aus der EP-A2-0 351 844 ist es bekannt, einen Hochtemperatursupraleiter vom Typ Bi-Sr-Ca-Cu-O mit einer Sprungtemperatur von 94 K und einer kritischen Stromdichte von 2 kA/cm$^2$ herzustellen. Nach einer 30minütigen Hitzebehandlung in Sauerstoffatmosphäre bei 900 °C wurde für 10 min auf 920 °C erhitzt und anschliessend 6 h bei 880 °C geglüht. Danach wurde mit einer Abkühlgeschwindigkeit von 2 K/min auf 600 °C abgekühlt, anschliessend in Stickstoffatmosphäre bis Zimmertemperatur.

Durch Jun-ichiro Kase et al., Partial Melt Growth Process of Bi$_2$Sr$_2$Ca$_1$Cu$_2$O$_x$ Textured Tapes on Silver, Japanese Journal of Applied Physics, Vol. 29, No. 7, July 1990, pp. L1096 - L1099, ist es bekannt, bei einer Temperatur von 77 K ohne äusseres Magnetfeld eine kritischen Stromdichte $j_c$ von 13 kA/cm$^2$ für orientierte Dickfilme zu erreichen.

Ein Nachteil dieses Verfahrens ist die Beschränkung auf Filmdicken < 100 μm.

Wie bei dem Verfahren nach der o. g. EP-A2-0 351 844 wird auch hier das Pulver, gepresst oder geschüttet, auf eine plane Unterlage, vorzugsweise aus Silber, aufgebracht. Unter Einwirkung der Gravitation im partiell geschmolzenen Zustand wird das Pulver zu einem kompakten Körper oder Film verdichtet. Bei nicht planen, z. B. zylindrischen Unterlagen versagt dieses Verfahren infolge eines ungleichmässigen Verlaufens bzw. Auslaufens der Flüssigkeit.

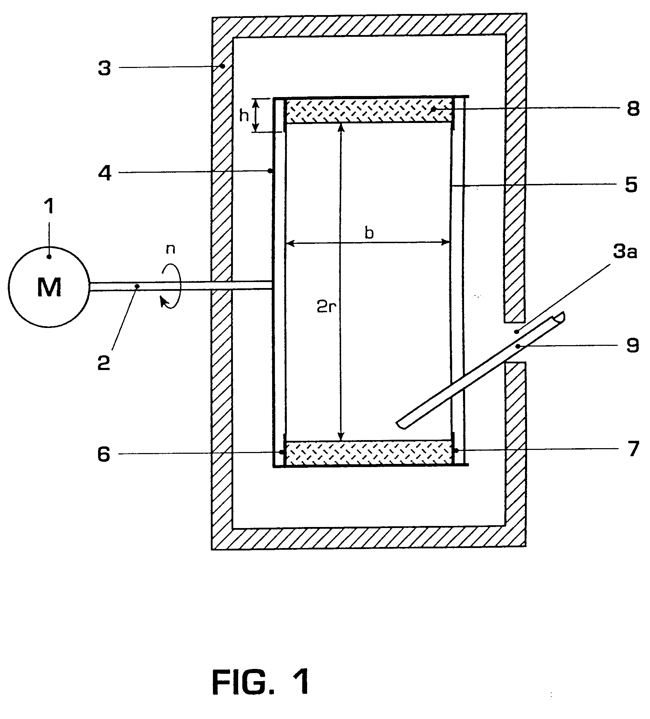

Aus dem Artikel von G. Triscone et al., Variation of the superconducting properties of Bi$_2$Sr$_2$CaCu$_2$O$_{8+x}$ with oxygen content, Physica C 176 (1991) S. 247 - 256, insbesondere aus Fig. 1 auf S. 248, ist es bekannt, wie die Sprungtemperatur $T_c$ vom Sauerstoffpartialdruck bei einer Gleichgewichts-Wärmebehandlung abhängt. Danach können Bi2212-Supraleiter beliebiger Herstellungsart und Grösse bezüglich der Sprungtemperatur optimiert werden.

## DARSTELLUNG DER ERFINDUNG

Die Erfindung, wie sie im Patentanspruch 1 definiert ist, löst die Aufgabe, ein Verfahren zur Herstellung eines rotationssymmetrischen Formteiles eines Hochtemperatursupraleiters der eingangs genannten Art derart weiterzuentwickeln, dass bei einer Temperatur von 77 K eine kritische Stromdichte von > 800 A/cm$^2$ erreicht werden kann.

Ein Vorteil der Erfindung besteht darin, dass bei gegebenem Leiterquerschnitt mit höheren Strömen gearbeitet werden kann. Es lassen sich z. B. Formstücke mit hoher Stromtragfähigkeit für Abschirmzwecke und für induktive Strombegrenzer herstellen.

Ein weiterer Vorteil besteht darin, dass die homogene Erstarrung der rotierenden Schmelze auch zu einem homogenen Gefüge des Formteils führt. Dadurch sind die supraleitenden Eigenschaften nicht abhängig von der Dicke des Zylinders, und es lassen sich auch Werkstücke mit einer Dicke von weniger als 2 mm unter Beibehaltung hoher Werte der kritischen Stromdichte herstellen.

Besonders vorteilhaft ist es, den Hochtemperatursupraleiter in der Schmelzform zu lassen, wenn er für Abschirmungszwecke eingesetzt werden soll. Dabei wirkt das in die Schmelzform eingesetzte Metall, z. B. Silber, als gutleitender Bypass.

## KURZE BESCHREIBUNG DER ZEICHNUNGEN

Die Erfindung wird nachstehend anhand von Ausführungsbeispielen erläutert. Es zeigen:

Fig. 1    einen Ofen mit motorbetriebener Schmelzform und

Fig. 2    ein Flussdiagramm des Herstellungsverfahrens eines rotationssymmetrischen Hochtemperatursupraleiters.

## WEGE ZUR AUSFÜHRUNG DER ERFINDUNG

In Fig. 1 ist mit (1) ein regelbarer Motor bezeichnet, der über eine Antriebswelle (2) mit einer Trommel bzw. Schmelzform (4) aus hochtemperaturfestem Stahl oder Keramik drehbar verbunden ist. Die in einem regelbaren Ofen (3) angeordnete, nur auf der rechten Seite offene Schmelzform (4) hat eine Tiefe bzw. Breite von 80 mm und einen Durchmesser von 200 mm. In die Schmelzform (4) ist eine Metallform bzw. ein Silberformteil bzw. ein profilförmig gebördeltes Silberblech (5) mit einem vorderen Anschlag (6) und einem hinteren Anschlag (7) eingelegt. Diese Anschläge (6, 7) weisen eine vorgebbare Randhöhe (h) auf. Das Silberblech (5) hat eine Dicke von 0,2 mm und eine Breite (b) von 70 mm.

Die Schmelzform (4) besteht aus einem hochwarmfesten Metall, dessen linearer Ausdehnungskoeffizient gleich oder bis zu 5 $\mu$m/m · K grösser als derjenige des Supraleiters ist. Die Metallform (5) aus einem gegenüber dem Supraleiter und dessen Schmelzphasen inerten Material, vorzugsweise aus Silber oder Gold oder aus einer Legierung dieser Metalle kann später als Armierung auf dem Supraleiter verbleiben.

In einer anderen Ausführung kann das Silber z. B. galvanisch als Schicht fest haftend auf die Schmelzform (4) aufgebracht sein. Die vorderen und hinteren Anschläge (6, 7) entfallen dann.

Als Ausgangsmaterial für ein partielles Schmelzen wird ein Pulvergemisch mit einer stöchiometrischen Zusammensetzung $Bi_{2 + x}EA_3Cu_2O_y$ verwendet, mit -0,15 < x < 0,4; EA = ein Erdalkalimetall oder ein Gemisch aus Erdalkalimetallen, insbesondere ein Gemisch aus Sr und Ca im Verhältnis Sr : Ca = (2 + z) : (1 - z) mit 0 < z < 0,2, vorzugsweise im Verhältnis 2,2 : 0,8; 8 $\leq$ y $\leq$ 8,3. Dem Pulver kann Silberpulver in einem Anteil bis zu 10 M% beigemischt sein. Dieses Pulvergemisch wird vor dem partiellen Schmelzen einem weiter unten beschriebenen Vorprozess unterworfen.

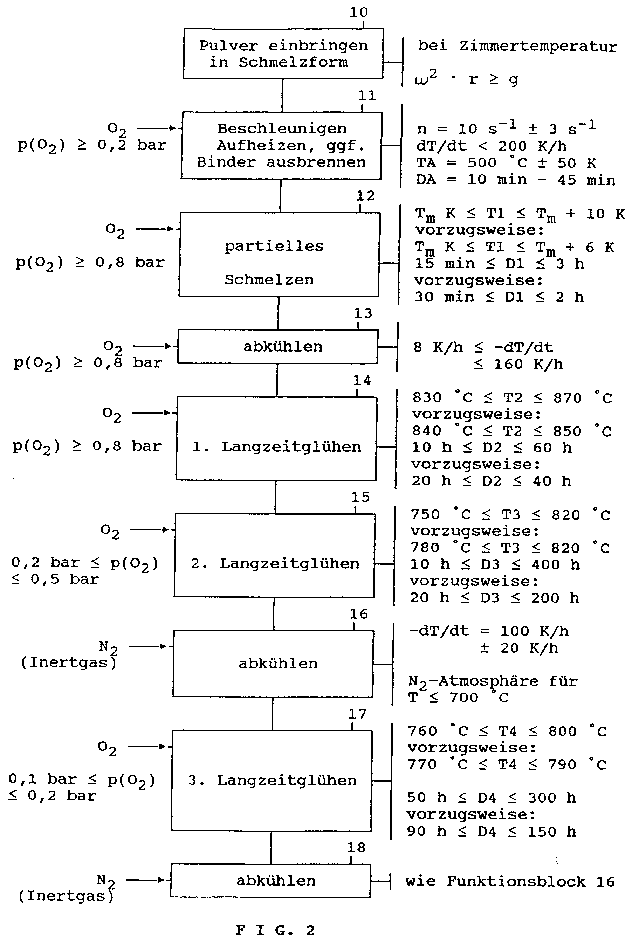

Dieses pulverförmige Ausgangsmaterial bzw. $Bi_2Sr_2CaCu_2O_8$-Pulver (8) wird entweder trocken oder als Suspension, bestehend aus Pulver, organischem Lösungsmittel und Binder, bei Zimmertemperatur über eine Förderrinne (9) in die Schmelzform (4) eingebracht. Die Förderrinne (9) ist durch eine verschliessbare Öffnung (3a) im Ofen (3) geführt. Während des Einbringens des Pulvers (8) muss eine Drehzahl (n) der Schmelzform (4) gross genug sein, damit die auf das Pulver (8) wirkende Zentrifugalbeschleunigung $\omega^2$ · r die Erdbeschleunigung (g) mindestens kompensiert, d. h., es muss $(2\pi n)^2$ · r $\geq$ g sein, r = Innenradius des Pulvers (8) in der Schmelzform (4), $\omega = 2\pi n$ = Kreisfrequenz, vgl. den Funktionsblock (10) in Fig. 2. Vorzugsweise sollte die Drehzahl (n) der Schmelzform (4) auf einen Wert n > $[1,3 \cdot g/(\pi^2 \cdot d)]^{0,5}$ gebracht werden, mit $\pi$ = 3,14, d = Durchmesser der Schmelzform (4).

Anhand von Fig. 2 wird das weitere Verfahren zur Herstellung eines rotationssymmetrischen Formteiles eines Hochtemperatursupraleiters erläutert.

Nach dem Einbringen des Pulvers (8) in die Schmelzform (4) wird deren Drehzahl (n), ähnlich einer Zentrifuge, auf einen Wert n = 10 s$^{-1}$ $\pm$ 3 s$^{-1}$ erhöht, um noch eine gewisse Kompaktierung des Pulvers zu erreichen. Die Ofenatmosphäre kann durch Einblasen von Gasen, wie z. B. $O_2$, $N_2$, Ar, definiert eingestellt werden. In gasdichter Ausführung sind Unter- und Überdrücke möglich. Wenn das Pulver (8) als Suspension eingebracht wurde, wird nun, unter Aufrechterhaltung der genannten Drehzahl (n), bei einem Sauerstoffpartialdruck p($O_2$) $\cong$ 0,2 bar, mit einer Aufheizgeschwindigkeit dT/dt < 200 K/h auf eine Ausbrenntemperatur (TA) von 500 °C $\pm$ 50 K aufgeheizt und während einer Ausbrenndauer (DA) im Bereich von 10 min - 45 min auf dieser Ausbrenntemperatur (TA) gehalten, vgl. Funktionsblock (11). Bei dieser Ausbrenntemperatur (TA) soll der Binder, falls vorhanden, ausgebrannt werden.

Auch während der weiteren, in Funktionsblöcken (12 - 18) angegebenen Verfahrensschritte bleibt das zu schmelzende und geschmolzene Pulver (8) in der Schmelzform (4), wobei Heiz- und Kühlgeschwindigkeiten stets < 300 K/h gehalten werden. Daher sind Schmelzform (4) und Hochtemperatursupraleiter isotherm. Somit werden starke thermische Gradienten vermieden, woraus ein dichtes, homogenes Gefüge resultiert.

Das partielle Schmelzen wird bei einer 1. Prozesstemperatur (T1) im Bereich von $T_m$ K $\leq$ T1 $\leq$ $T_m$ + 10 K, vorzugsweise in einem Temperaturbereich von $T_m$ K $\leq$ T1 $\leq$ $T_m$ + 6 K während einer 1. Prozessdauer (D1) in einem Bereich von 15 min $\leq$ D1 $\leq$ 3 h vorzugsweise in einem Bereich von 30 min $\leq$ D1 $\leq$ 2 h bei einem Sauerstoffpartialdruck p($O_2$) $\cong$ 0,8 bar durchgeführt; $T_m$ = Schmelztemperatur, vgl. Funktionsblock (12). Wenn die Schmelztemperatur des pulverförmigen Ausgangsmaterials mit zunehmender Schmelzdauer sinkt, dann wird die Ofentemperatur entsprechend gesenkt. Das partielle Schmelzen des Pulvers (8) erfolgt bei ca. 880 °C - 930 °C.

Anschliessend wird die Probe gemäss Funktionsblock (13) bei einem Sauerstoffpartialdruck p($O_2$) $\cong$ 0,8 bar mit einer Abkühlgeschwindigkeit (-dT/dt) von 8 K/h $\leq$ -dT/dt $\leq$ 160 K/h auf eine 2. Prozesstemperatur (T2) eines nachfolgenden 1. Langzeitglühens abgekühlt.

Das 1. Langzeitglühen gemäss Funktionsblock (14) erfolgt bei einem Sauerstoffpartialdruck p($O_2$) $\cong$ 0,8 bar bei der 2. Prozesstemperatur (T2) in einem Temperaturbereich von 830 °C $\leq$ T2 $\leq$ 870 °C, vorzugsweise in einem Temperaturbereich von 840 °C $\leq$ T2 $\leq$ 850 °C während einer 2. Prozessdauer (D2) in einem Zeitdauerbereich von 10 h $\leq$ D2 $\leq$ 60 h, vorzugsweise in einem Zeitdauerbereich von 20 h $\leq$ D2 $\leq$ 40 h. Da bei der 1. Langzeitglühung und den folgenden Prozeßschritten der Supraleiter erstarrt und zusammenhängend ist, kann von hier ab auf Rotation verzichtet werden.

Ein anschliessendes 2. Langzeitglühen gemäss Funktionsblock (15) erfolgt bei einem Sauerstoffpartial-

druck p(O$_2$) in einem Druckbereich von 0,2 bar $\leq$ p(O$_2$) $\leq$ 0,5 bar bei der 3. Prozesstemperatur (T3) in einem Temperaturbereich von 750 °C $\leq$ T3 $\leq$ 820 °C, vorzugsweise in einem Temperaturbereich von 780 °C $\leq$ T3 $\leq$ 820 °C während einer 3. Prozessdauer (D3) in einem Zeitdauerbereich von 10 h $\leq$ D3 $\leq$ 400 h, vorzugsweise in einem Zeitdauerbereich von 20 h $\leq$ D3 $\leq$ 200 h.

Danach wird abgekühlt, vgl. Funktionsblock (15), mit einer Abkühlgeschwindigkeit -dT/dt = 100 K/h $\pm$ 20 K/h, wobei das Abkühlen bei Temperaturen T $\leq$ 700 °C in einer Inertgasatmosphäre, vorzugsweise in Stickstoffatmosphäre durchgeführt wird.

In einer alternativen Durchführung des Verfahrens kann der Ofen (3) nach dem partiellen Schmelzen auf Zimmertemperatur abgekühlt werden. Die weiteren Prozeßschritte können in einem anderen, nicht dargestellten Ofen ohne Rotation durchgeführt werden.

Zur Optimierung der Sprungtemperatur T$_c$ kann darauf eine 3. Langzeitglühung gemäss Funktionsblock (17) durchgeführt werden, bei einem Sauerstoffpartialdruck p(O$_2$) in einem Druckbereich von 0,1 bar $\leq$ p(O$_2$) $\leq$ 0,2 bar bei einer 4. Prozesstemperatur (T4) in einem Temperaturbereich von 760 °C $\leq$ T4 $\leq$ 800 °C, vorzugsweise in einem Temperaturbereich von 770 °C $\leq$ T4 $\leq$ 790 °C während einer 4. Prozessdauer (D4) in einem Zeitdauerbereich von 50 h $\leq$ D4 $\leq$ 300 h, vorzugsweise in einem Bereich von 90 h $\leq$ D4 $\leq$ 150 h.

Das anschliessende Abkühlen im Funktionsblock (18) erfolgt gleich demjenigen gemäss Funktionsblock (16).

Beispiel 1:

In einer Silberform (5) mit einem Durchmesser von 200 mm, einer Breite (b) von 80 mm und einer Randhöhe (h) von 10 mm wurde bei einer Drehzahl (n) von 2,5 s$^{-1}$ 700 g Bi$_2$Sr$_2$CaCu$_2$O$_8$-Pulver (8) gleichmässig verteilt. Während des Aufheizens wurde die Drehzahl (n) auf ca. 10 s$^{-1}$ zur Materialkompaktierung erhöht. Bei Schmelztemperaturen wurde wieder mit einer langsameren Drehzahl (n) gefahren, um Phasentrennungen zu vermeiden. Dann wurde unter einer 1-bar-O$_2$-Atmosphäre mit einer Aufheizgeschwindigkeit von 60 K/h auf 900 °C aufgeheizt und diese Temperatur zum Aufschmelzen des pulverförmigen Ausgangsmaterials 2 h lang gehalten. Das anschliessende Abkühlen auf 850 °C erfolgte mit einer Abkühlgeschwindigkeit von 60 K/h. Die Temperatur von 850 °C wurde 60 h lang gehalten. Danach wurde auf 700 °C abgekühlt. Das Abkühlen auf Zimmertemperatur erfolgte mit einer Abkühlgeschwindigkeit von 100 K/h in N$_2$-Atmosphäre. Der so erhaltene supraleitende Zylinder hatte eine Wandstärke von 2,5 mm und liess sich problemlos aus der Silberform (5) schälen. Die kritische Stromdichte (j$_c$) betrug 850 A/cm$^2$.

Beispiel 2:

Anstelle der Silberform (5) gemäss Beispiel 1 wurde eine zylindrische Form aus einer hochwärmefesten Ni-Cr-Legierung oder einer Fe-Ni-Legierung mit einer Wandstärke von 1 mm, einem Durchmesser von 200 mm, einer Breite (b) von 8 mm und einer Randhöhe (h) von 3 mm verwendet, die galvanisch mit einer Silberschicht von 50 $\mu$m beschichtet war. In diese Form wurde unter Rotation, wie oben beschrieben, soviel von einer Suspension an feinkörnigem Bi$_2$Sr$_2$CaCu$_2$O$_8$-Pulver (8) mit einer Korngrösse $\leq$ 5 $\mu$m eingebracht, dass die getrocknete Auflage aus Bi$_2$Sr$_2$CaCu$_2$O$_8$-Pulver (8) und Binder ca. 0,2 mm betrug. Im Unterschied zum Heizprogramm gemäss Beispiel 1 enthielt die Ofenatmosphäre künstliche Luft mit 0,2 bar O$_2$ in 0,8 bar N$_2$. Die Verweilzeit bei 900 °C betrug nur 10 min. Das Abkühlen von der Schmelztemperatur (T$_m$) auf die Haltetemperatur bei 850 °C erfolgte mit einer Abkühlgeschwindigkeit von 10 K/h. Damit erhielt man eine ca. 50 $\mu$m dicke Schicht mit sehr guter Orientierung der kristallographischen c-Achse senkrecht zur Rotationsachse mit einer kritischen Stromdichte (j$_c$) von ca. 8 kA/cm$^2$ bei 77 K. Dieser Hochtemperatursupraleiter wird vorzugsweise ohne Trennung von der Unterlage in Strombegrenzern eingesetzt, da die äussere Form (5) mit dem Silber als mechanische und elektrische Stütze wirkt.

Bei allen Beispielen lag die kritische Übergangstemperatur T$_c$ oberhalb 93 K.

BEZEICHNUNGSLISTE

| | |
|---|---|
| 1 | Motor |
| 2 | Antriebswelle |
| 3 | Ofen |
| 4 | Trommel, Schmelzform |
| 5 | Silberblech, Silberform, Metallform |
| 6 | vorderer Anschlag von 5 |
| 7 | hinterer Anschlag von 5 |
| 8 | Pulvergemisch, Pulver in 5 |
| 9 | Förderrinne |
| 10 - 18 | Funktionsblöcke |
| b | Breite |
| DA | Ausbrenndauer |
| D1 - D4 | 1. - 4. Prozessdauer |
| h | Randhöhe von 5 |
| j$_c$ | kritische Stromdichte |
| n | Drehzahl |
| p(O$_2$) | Sauerstoffpartialdruck |
| r | Innenradius von 8 |
| T | Temperatur |
| T1 - T4 | 1. - 4. Prozesstemperatur |
| T$_m$ | Schmelztemperatur |

**Patentansprüche**

1. Verfahren zur Herstellung eines rotationssymmetrischen Formteiles eines Hochtemperatursupraleiters aus einem pulverförmigen Ausgangsmaterial,

a) wobei das Formteil in einer rotierenden Schmelzform (4) bei einer 1. Prozesstemperatur (T1) oberhalb der Schmelztemperatur ($T_m$) des Hochtemperatursupraleiters seine rotationssymmetrische Form erhält und
b) die Drehzahl (n) der Schmelzform (4) mindestens so gross ist, dass die auf das Ausgangsmaterial wirkende Zentrifugalkraft mindestens gleich der Erdanziehungskraft ist,

dadurch gekennzeichnet,

c) dass pulverförmiges Ausgangsmaterial in die rotierende Schmelzform (4) eingebracht wird und
d) dass anschliessend durch Aufschmelzen bei der 1. Prozesstemperatur (T1) und Erstarrenlassen in der Schmelzform (4) ein festes, zusammenhängendes Werkstück geformt wird.

2. Verfahren nach Anspruch 1, dadurch gekennzeichnet,

a) dass das pulverförmige Ausgangsmaterial in der Schmelzform (4) bei der 1. Prozesstemperatur (T1) in einem Temperaturbereich von $T_m K \leq T1 \leq T_m + 10 K$
b) während einer 1. Prozessdauer (D1) in einem Zeitdauerbereich von 15 min $\leq$ D1 $\leq$ 3 h geschmolzen wird, $T_m$ = Schmelztemperatur des pulverförmigen Ausgangsmaterials.

3. Verfahren nach Anspruch 1 oder 2, dadurch gekennzeichnet,

a) dass das Schmelzen bei der 1. Prozesstemperatur (T1) in einem Temperaturbereich von

$$T_m K \leq T1 \leq T_m + 6 K$$

b) während der 1. Prozessdauer (D1) in einem Zeitdauerbereich von 30 min $\leq$ D1 $\leq$ 2 h durchgeführt wird.

4. Verfahren nach einem der Ansprüche 1 bis 3, dadurch gekennzeichnet,

a) dass das pulverförmige Ausgangsmaterial in flüssiger Suspension bei Zimmertemperatur in die Schmelzform (4) eingebracht wird und
b) dass während des Aufheizens auf eine Ausbrenntemperatur (TA) von 500 °C $\pm$ 50 K die Drehzahl (n) der Schmelzform (4) auf einen Wert n > $[1,3 \cdot g/(\pi^2 \cdot d)]^{0,5}$ gebracht wird, mit $\pi$ = 3,14, d = Durchmesser der Schmelzform (4), g = Erdbeschleunigung.

5. Verfahren nach einem der Ansprüche 1 bis 4, dadurch gekennzeichnet,

a) dass das Schmelzen bei einem Sauerstoffpartialdruck $p(O_2) \geq 0,8$ bar durchgeführt wird und
b) dass ein Abkühlen auf Zimmertemperatur unterhalb von 700 °C in Stickstoffatmosphäre erfolgt.

6. Verfahren nach einem der Ansprüche 1 bis 5, dadurch gekennzeichnet,

a) dass nach dem Schmelzen mit einer Abkühlgeschwindigkeit (-dT/dt) von 8 K/h $\leq$ -dT/dt $\leq$ 160 K/h auf eine 2. Prozesstemperatur (T2) abgekühlt wird,
b) dass ein 1. Langzeitglühen bei der 2. Prozesstemperatur (T2) in einem Temperaturbereich von 830 °C $\leq$ T2 $\leq$ 870 °C
c) während einer 2. Prozessdauer (D2) in einem Zeitbereich von 10 h $\leq$ D2 $\leq$ 60 h
d) bei einem Sauerstoffpartialdruck $p(O_2) \geq 0,8$ bar durchgeführt wird,
e) insbesondere, dass das 1. Langzeitglühen bei der 2. Prozesstemperatur (T2) in einem Temperaturbereich von 840 °C $\leq$ T2 $\leq$ 850 °C durchgeführt wird,
f) insbesondere, dass die Schmelzform (4) mit dem erschmolzenen Werkstück nach dem Schmelzen ohne Rotation auf Zimmertemperatur abgekühlt wird.

7. Verfahren nach einem der Ansprüche 1 bis 6, dadurch gekennzeichnet,

a) dass ein 2. Langzeitglühen bei einer 3. Prozesstemperatur (T3) in einem Temperaturbereich von 750 °C $\leq$ T3 $\leq$ 820 °C
b) während einer 3. Prozessdauer (D3) in einem Zeitbereich von 10 h $\leq$ D3 $\leq$ 400 h
c) bei einem Sauerstoffpartialdruck $p(O_2)$ im Bereich 0,2 bar $\leq$ $p(O_2)$ $\leq$ 0,5 bar durchgeführt wird,
d) insbesondere, dass das 2. Langzeitglühen bei einer 3. Prozesstemperatur (T3) in einem Temperaturbereich von 780 °C $\leq$ T3 $\leq$ 820 °C
e) während einer 3. Prozessdauer (D3) in einem Zeitbereich von 20 h $\leq$ D3 $\leq$ 200 h durchgeführt wird.

8. Verfahren nach einem der Ansprüche 1 bis 7, dadurch gekennzeichnet,

a) dass nach dem Abkühlen auf Zimmertemperatur ein 3. Langzeitglühen bei einer 4. Prozesstemperatur (T4) in einem Temperaturbereich von 760 °C $\leq$ T4 $\leq$ 800 °C

b) während einer 4. Prozessdauer (D4) in einem Zeitbereich von 50 h $\leq$ D4 $\leq$ 300 h

c) bei einem Sauerstoffpartialdruck $p(O_2)$ im Bereich 0,1 bar $\leq p(O_2) \leq$ 0,2 bar durchgeführt wird,

c) insbesondere, dass das 3. Langzeitglühen bei einer 4. Prozesstemperatur (T4) in einem Temperaturbereich von 770 °C $\leq$ T4 $\leq$ 790 °C

d) während einer 4. Prozessdauer (D4) in einem Zeitbereich von 90 h $\leq$ D4 $\leq$ 150 h durchgeführt wird.

9. Verfahren nach einem der Ansprüche 1 bis 8, dadurch gekennzeichnet,

    a) dass die Schmelzform (4) aus einem hochwarmfesten Metall besteht, dessen linearer Ausdehnungskoeffizient gleich oder bis zu 5 $\mu$m/m · K grösser als derjenige des Supraleiters ist,
    b) dass die Schmelzform (4) innenseitig mit einer Metallform (5) aus einem Material ausgekleidet oder beschichtet ist, welches gegenüber dem Supraleiter und dessen Schmelzphasen inert ist, und
    c) dass diese Metallform (5) als Armierung und elekrische Stabilisierung auf dem Supraleiter verbleibt,
    d) insbesondere, dass die Metallform (5) aus Silber oder Gold oder aus einer Legierung dieser Metalle besteht.

10. Verfahren nach einem der Ansprüche 1 bis 9, dadurch gekennzeichnet,

    a) dass der Hochtemperatursupraleiter vom Typ $Bi_{2+x}EA_3Cu_2O_y$ ist, mit -0,15 < x < 0,4, EA = ein Erdalkalimetall oder ein Gemisch aus Erdalkalimetallen, inbesondere ein Gemisch aus Sr und Ca im Verhältnis Sr : Ca = (2 + z) : (1 - z) mit

$$0 < z < 0,2,$$

$$8 \leq y \leq 8,3,$$

    b) dass das pulverförmige Ausgangsmaterial durch mehrfaches Kalzinieren und jeweils nachfolgendes Aufmahlen hergestellt wird,
    c) insbesondere, dass dem fertig reagierten Pulver Silberpulver in einer Konzentration von bis zu 10 M% beigemischt wird.

**Claims**

1. Method for producing a rotationally symmetrical moulded part of a high-temperature superconductor made from a pulverulent starting material,

    a) the moulded part being given its rotationally symmetrical shape in a rotating fusion mould (4) at a first process temperature (T1) above the melting temperature ($T_m$) of the high-tem-perature superconductor and
    b) the rotational speed (n) of the fusion mould (4) being at least so large that the centrifugal force acting on the starting material is at least equal to the Earth's gravitational attraction,

characterized in that

    c) pulverulent starting material is introduced into the rotating fusion mould (4), and
    d) in that a solid, coherent workpiece is subsequently formed by melting at the first process temperature (T1) and solidification in the fusion mould (4).

2. Method according to Claim 1, characterized in that

    a) the pulverulent starting material is melted in the fusion mould (4) at the first process temperature (T1) in a temperature range of $T_m$ K $\leq$ T1 $\leq T_m$ + 10 K
    b) during a first process period (D1) in a period range of 15 min $\leq$ D1 $\leq$ 3 h, where $T_m$ = melting temperature of the pulverulent starting material.

3. Method according to Claim 1 or 2, characterized in that

    a) the melting is carried out at the first process temperature (T1) in a temperature range of

$$T_m \text{ K} \leq \text{T1} \leq T_m + 6 \text{ K}$$

    b) during the first process period (D1) in a period range of 30 min $\leq$ D1 $\leq$ 2 h.

4. Method according to one of Claims 1 to 3, characterized in that

    a) the pulverulent starting material is introduced into the fusion mould (4) in liquid suspension at room temperature, and
    b) in that during heating to a burn-out temperature (TA) of 500°C $\pm$ 50 K the rotational speed (n) of the fusion mould (4) is brought to a value of n > $[1.3 \cdot g/(\pi^2 \cdot d)]^{0.5}$, where $\pi$ = 3.14, d = diameter of the fusion mould (4), and g = acceleration due to gravity.

5. Method according to one of Claims 1 to 4, characterized in that

    a) melting is carried out at an oxygen partial pressure of $p(O_2) \geq$ 0.8 bar, and

b) in that cooling to room temperature is performed below 700°C in a nitrogen atmosphere.

6. Method according to one of Claims 1 to 5, characterized in that

a) after melting cooling is carried out at a cooling rate (-dT/dt) of 8 K/h $\leq$ dT/dt $\leq$ 160 K/h at a second process temperature (T2),
b in that a first long-term annealing is carried out at the second process temperature (T2) in a temperature range of 830°C $\leq$ T2 $\leq$ 870°C
c) during a second process period (D2) in a time range of 10 h $\leq$ D2 $\leq$ 60 h
d) at an oxygen partial pressure of $p(O_2) \geq 0.8$ bar,
e) in particular, in that the first long-term annealing at the second process temperature (T2) is carried out in a temperature range of 840°C $\leq$ T2 $\leq$ 850°C, and
f) in particular, in that the fusion mould (4) with the melted workpiece is cooled after melting to room temperature without rotation.

7. Method according to one of Claims 1 to 6, characterized in that

a) a second long-term annealing is carried out at a third process temperature (T3) in a temperature range of 750°C $\leq$ T3 $\leq$ 820°C
b) during a third process period (D3) in a time range of 10 h $\leq$ D3 $\leq$ 400 h
c) at an oxygen partial pressure of $p(O_2)$ in the range of 0.2 bar $\leq p(O_2) \leq$ 0.5 bar,
d) in particular, in that the second long-term annealing is carried out at a third process temperature (T3) in a temperature range of 780°C $\leq$ T3 $\leq$ 820°C
e) during a third process period (D3) in a time range of 20 h $\leq$ D $\leq$ 200 h.

8. Method according to one of Claims 1 to 7, characterized in that

a) after cooling to room temperature a third long-term annealing is carried out at a fourth process temperature (T4) in a temperature range of 760°C $\leq$ T4 $\leq$ 800°C
b) during a fourth process period (D4) in a time range of 50 h $\leq$ D4 $\leq$ 300 h
c) at an oxygen partial pressure of $p(O_2)$ in the range of 0.1 bar $\leq p(O_2) \leq$ 0.2 bar,
d) in particular, in that the third long-term annealing is carried out at a fourth process temperature (T4) in a temperature range of 770°C $\leq$ T4 $\leq$ 790°C
d) during a fourth process period (D4) in a time range of 90 h $\leq$ D4 $\leq$ 150 h.

9. Method according to one of Claims 1 to 8, characterized in that

a) the fusion mould (4) consists of a high-temperature resistant metal whose coefficient of linear expansion is equal to or up to 5 $\mu$m/m · K larger than that of the superconductor,
b) in that the fusion mould (4) is lined or coated on the inside with a metal mould (5) made from a material which is inert with respect to the superconductor and its melting phases, and
c) in that this metal mould (5) remains as armouring and electrical stabilization on the superconductor, and
d) in particular, in that the metal mould (5) consists of silver or gold or of an alloy of these metals.

10. Method according to one of Claims 1 to 9, characterized in that

a) the high-temperature superconductor is of the type $Bi_{2+x}EA_3Cu_2O_y$, where -0.15 < x < 0.4, and EA = an alkaline earth metal or a mixture of alkaline earth metals, in particular a mixture of Sr and Ca in the ratio of Sr : Ca = (2 + z) : (1 - z), where

$$0 < z < 0.2,$$

$$8 \leq y \leq 8.3,$$

b) in that the pulverulent starting material is produced by multiple calcinating and grinding which follows in each case, and
c) in particular, in that silver powder at a concentration of up to 10 M% [sic] is admixed with the finally reacted powder.

Revendications

1. Procédé pour la fabrication d'une pièce de forme à symétrie de révolution en un matériau supraconducteur à haute température à partir d'une matière première pulvérulente, dans lequel

a) la pièce de forme reçoit sa forme à symétrie de révolution dans un moule de fusion tournant (4) à une 1$^{ère}$ température de traitement (T1) au-dessus de la température de fusion ($T_m$) du matériau supraconducteur, et
b) la vitesse de rotation (n) du moule de fusion (4) est au moins égale à celle pour laquelle la force centrifuge agissant sur la matière première est au moins égale à la force d'attraction terrestre,

caractérisé en ce que

c) une matière première pulvérulente est introduite dans le moule de fusion tournant (4) et en ce que

d) par fusion à la 1ère température de traitement (T1) et solidification dans le moule de fusion (4), il se forme ensuite une pièce solide et cohérente.

2. Procédé suivant la revendication 1, caractérisé en ce que

a) la matière première pulvérulente est fondue dans le moule de fusion (4) à la 1ère température de traitement (T1) dans une gamme de températures de

$$T_m \, K \leqq T1 \leqq T_m + 10 \, K,$$

b) pendant une 1ère durée de traitement (D1) dans une gamme de durées de 15 min $\leqq$ D1 $\leqq$ 3 h, $T_m$ = température de fusion de la matière première pulvérulente.

3. Procédé suivant la revendication 1 ou 2, caractérisé en ce que

a) la fusion est effectuée à une 1ère température de traitement (T1) dans une gamme de températures de

$$T_m \, K \leqq T1 \leqq T_m + 6 \, K$$

b) pendant une 1ère durée de traitement (D1) dans une gamme de durées de 30 min $\leqq$ D1 $\leqq$ 2 h.

4. Procédé suivant l'une quelconque des revendications 1 à 3, caractérisé en ce que

a) la matière première pulvérulente est introduite dans le moule de fusion (4) en suspension liquide à la température ambiante, et en ce que

b) pendant le chauffage à une température de cuisson (TA) de 500°C ± 50 K, la vitesse de rotation (n) du moule de fusion (4) est portée à une valeur n > $[1,3 \cdot g/(\pi^2 \cdot d)]^{0,5}$, avec $\pi$ = 3,14, d = diamètre du moule de fusion (4) et g = accélération terrestre.

5. Procédé suivant l'une quelconque des revendications 1 à 4, caractérisé en ce que

a) la fusion est effectuée sous une pression partielle d'oxygène p(O$_2$) $\geqq$ 0,8 bar, et en ce que

b) un refroidissement à la température ambiante est effectué en dessous de 700°C dans une atmosphère d'azote.

6. Procédé suivant l'une quelconque des revendications 1 à 5, caractérisé en ce que

a) après la fusion, on refroidit avec une vitesse de refroidissement (-dT/dt) de 8 K/h $\leqq$ -dT/dt $\leqq$ 160 K/h jusqu'à une 2e température de traitement (T2), en ce que

b) on effectue un 1er recuit de longue durée à la 2e température de traitement (T2) dans une gamme de températures de 830°C $\leqq$ T2 $\leqq$ 870°C,

c) pendant une 2e durée de traitement (D2) dans une gamme de durées de 10 h $\leqq$ D2 $\leqq$ 60 h

d) sous une pression partielle d'oxygène p(O$_2$) $\geqq$ 0,8 bar

e) en particulier en ce que le 1er recuit de longue durée est effectué à la 2e température de traitement (T2) dans une gamme de températures de 840°C $\leqq$ T2 $\leqq$ 850°C,

f) en particulier en ce que le moule de fusion (4) avec la pièce fondue est refroidi à la température ambiante, après la fusion, sans rotation.

7. Procédé suivant l'une quelconque des revendications 1 à 6, caractérisé en ce que

a) un 2e recuit de longue durée est effectué à une 3e température de traitement (T3) dans une gamme de températures de 750°C $\leqq$ T3 $\leqq$ 820°C,

b) pendant une 3e durée de traitement (D3) dans une gamme de durées de 10 h $\leqq$ D3 $\leqq$ 400 h,

c) sous une pression partielle d'oxygène p(O$_2$) dans la gamme de 0,2 bar $\leqq$ p(O$_2$) $\leqq$ 0,5 bar,

d) en particulier en ce que le 2e recuit de longue durée est effectué à une 3e température de traitement (T3) dans une gamme de températures de 780°C $\leqq$ T3 $\leqq$ 820°C,

e) pendant une 3e durée de traitement (D3) dans une gamme de durées de 20 h $\leqq$ D3 $\leqq$ 200 h.

8. Procédé suivant l'une quelconque des revendications 1 à 7, caractérisé en ce que

a) après le refroidissement à la température ambiante, on effectue un 3e recuit de longue durée à une 4e température de traitement (T4) dans une gamme de températures de 760°C $\leqq$ T4 $\leqq$ 800°C

b) pendant une 4e durée de traitement (D4) dans une gamme de durées de 50 h $\leqq$ D4 $\leqq$ 300 h

c) sous une pression partielle d'oxygène p(O$_2$) dans la gamme de 0,1 bar $\leqq$ p(O$_2$) $\leqq$ 0,2 bar,

d) en particulier en ce que le 3e recuit de longue durée est effectué à une 4e température de traitement (T4) dans une gamme de températures de 770°C $\leq$ T4 $\leq$ 790°C

e) pendant une 4e durée de traitement (D4) dans une gamme de durées de 90 h $\leq$ D4 $\leq$ 150 h.

9. Procédé suivant l'une quelconque des revendications 1 à 8, caractérisé en ce que

a) le moule de fusion (4) se compose d'un métal résistant à chaud, dont le coefficient de dilatation linéaire est égal à ou est jusqu'à 5 $\mu$m/m $\cdot$ K plus élevé que celui du matériau supraconducteur, en ce que

b) le moule de fusion (4) est revêtu ou recouvert intérieurement avec une forme métallique (5) en un matériau qui est inerte vis-à-vis du matériau supraconducteur et des phases fondues de celui-ci, et en ce que

c) cette forme métallique (5) demeure sur le matériau supraconducteur en guise d'armature et de stabilisation électrique,

d) en particulier en ce que la forme métallique (5) se compose d'argent ou d'or ou d'un alliage de ces métaux.

10. Procédé suivant l'une quelconque des revendications 1 à 9, caractérisé en ce que

a) le matériau supraconducteur à haute température est du type $Bi_{2+x}EA_3Cu_2O_y$, avec -0,15 < x < 0,4, EA = un metal alcalino-terreux ou un mélange de métaux alcalino-terreux, en particulier un mélange de Sr et Ca dans le rapport Sr : Ca = (2 + z) : (1 - z) avec 0 < z < 0,2 et 8 $\leq$ y $\leq$ 8,3; en ce que

b) la matière première pulvérulente est fabriquée par calcination multiple chaque fois suivie de broyage,

c) en particulier en ce que l'on ajoute à la poudre ayant finalement réagi, de la poudre d'argent en une concentration pouvant atteindre jusqu'à 10 % en masse.

**FIG. 1**

| | | |
|---|---|---|
| | **10** Pulver einbringen in Schmelzform | bei Zimmertemperatur $\omega^2 \cdot r \geq g$ |
| $O_2$ <br> $p(O_2) \geq 0,2$ bar | **11** Beschleunigen Aufheizen, ggf. Binder ausbrennen | $n = 10\ s^{-1} \pm 3\ s^{-1}$ <br> $dT/dt < 200$ K/h <br> TA = 500 °C ± 50 K <br> DA = 10 min – 45 min |
| $O_2$ <br> $p(O_2) \geq 0,8$ bar | **12** partielles Schmelzen | $T_m$ K $\leq$ T1 $\leq$ $T_m$ + 10 K <br> vorzugsweise: <br> $T_m$ K $\leq$ T1 $\leq$ $T_m$ + 6 K <br> 15 min $\leq$ D1 $\leq$ 3 h <br> vorzugsweise: <br> 30 min $\leq$ D1 $\leq$ 2 h |
| $O_2$ <br> $p(O_2) \geq 0,8$ bar | **13** abkühlen | 8 K/h $\leq$ -dT/dt <br> $\leq$ 160 K/h |
| $O_2$ <br> $p(O_2) \geq 0,8$ bar | **14** 1. Langzeitglühen | 830 °C $\leq$ T2 $\leq$ 870 °C <br> vorzugsweise: <br> 840 °C $\leq$ T2 $\leq$ 850 °C <br> 10 h $\leq$ D2 $\leq$ 60 h <br> vorzugsweise: <br> 20 h $\leq$ D2 $\leq$ 40 h |
| $O_2$ <br> 0,2 bar $\leq$ $p(O_2)$ $\leq$ 0,5 bar | **15** 2. Langzeitglühen | 750 °C $\leq$ T3 $\leq$ 820 °C <br> vorzugsweise: <br> 780 °C $\leq$ T3 $\leq$ 820 °C <br> 10 h $\leq$ D3 $\leq$ 400 h <br> vorzugsweise: <br> 20 h $\leq$ D3 $\leq$ 200 h |
| $N_2$ (Inertgas) | **16** abkühlen | -dT/dt = 100 K/h <br> ± 20 K/h <br><br> $N_2$-Atmosphäre für T $\leq$ 700 °C |
| $O_2$ <br> 0,1 bar $\leq$ $p(O_2)$ $\leq$ 0,2 bar | **17** 3. Langzeitglühen | 760 °C $\leq$ T4 $\leq$ 800 °C <br> vorzugsweise: <br> 770 °C $\leq$ T4 $\leq$ 790 °C <br><br> 50 h $\leq$ D4 $\leq$ 300 h <br> vorzugsweise: <br> 90 h $\leq$ D4 $\leq$ 150 h |
| $N_2$ (Inertgas) | **18** abkühlen | wie Funktionsblock 16 |

F I G. 2